# EUROPÄISCHE PATENTSCHRIFT

(11) **EP 0 693 772 B1**
(45) Veröffentlichungstag und Bekanntmachung des Hinweises auf die Patenterteilung: **07.11.2001**
(21) Anmeldenummer: 95110376.1
(22) Anmeldetag: 04.07.1995
(51) Int. Cl.: H01L 21/285, H01L 21/768

(54) **Verfahren zum Kontaktieren von SIPOS passivierten Halbleiteranordnungen**
Process for contacting SIPOS passivated semiconductor devices
Procédé pour contacter des dispositifs semi-conducteurs passivés SIPOS

(30) Priorität: 12.07.1994 DE 4424420
(43) Veröffentlichungstag der Anmeldung: 24.01.1996
(73) Patentinhaber: Vishay Semiconductor GmbH, 74072 Heilbronn (DE)
(72) Erfinder: Harmel, Hartmut, D-34369 Hofgeismar (DE); Kellner-Werdehausen, Uwe, D-91362 Pretzfeld (DE)
(74) Vertreter: Maute, Hans-Jürgen, Dipl.-Ing.

(56) Entgegenhaltungen:
- EP-A- 0 519 268
- EP-A- 0 589 210
- GB-A- 2 128 636
- US-A- 4 648 175
- US-A- 4 717 681
- US-A- 5 086 332
- PROCEEDINGS OF THE 14TH EUROPEAN SOLID STATE DEVICE RESEARCH CONFERENCE, INCLUDING SOLID STATE DEVICE TECHNOLOGY, LILLE, FRANCE, 10-13 SEPT. 1984, Bd. 129B+C, Nr. 1-3, ISSN 0378-4363, PHYSICA B & C, MARCH 1985, NETHERLANDS, Seiten 234-239, XP000653623 SANDOE J N ET AL: "Characterisation and modelling of SIPOS on silicon planar devices"

## Beschreibung

Die Erfindung bezieht sich auf ein Verfahren nach dem Oberbegriff des Anspruchs 1.

Es ist bekannt, zur Herstellung von Halbleiterbauelementen, insbesondere von Hochspannungs-Leistungstransistoren, sogenannte SIPOS-Passivierungsschichten (Semi-Insulating-Poly-Silicon) zu verwenden. Im allgemeinen handelt es sich hierbei um eine Doppelschicht, wobei die erste Schicht aus O-SIPOS (sauerstoffdotiert) und die zweite Schicht aus N-SIPOS (stickstoffdotiert) besteht. Zur Herstellung einer solchen SIPOS-Doppelschicht wird üblicherweise ein CVD-Verfahren (Chemical Vapour Deposition) eingesetzt.

Bevor die zu kontaktierenden Stellen bespielsweise der Emitter- oder Basiszonen mit einer meist aus Aluminium bestehenden Leitbahn in Berührung kommen können, muß zuerst mit Hilfe eines sogenannten Kontaktöffnungsprozesses dafür gesorgt werden, daß die zuvor in anderen Verfahrensschritten aufgebrachten N-SIPOS-, O-SIPOS-und Oxidschichten von diesen Stellen wieder entfernt werden. Häufig wird die Kontaktöffnung durch eine naßchemische Ätzung herbeigeführt, seltener durch ein Plasmaätzverfahren, da der zusätzliche technologische Aufwand hierfür erheblich ist. Eine weitere, ebenfalls mit hohem technologischem Aufwand verbundene Möglichkeit besteht darin, den Kontakt mit mehreren Maskenschritten herzustellen. Jedoch wird der Kontaktöffnungsprozeß in den meisten Fällen als die mit geringem technologischem Aufwand verbundene naßchemische Ätzung ausgeführt. Nachteilig hierbei sind die bei diesen Ätzverfahren durch Unterätzung häufig auftretenden Hohlräume zwischen den Passivierungsschichten und einer Leitbahn und Leitbahnunterbrechungen.

Es sind noch weitere Dokumente bekannt, in denen Kontaktierungen bzw. SIPOS-Schichten eine besondere Rolle spielen.

Das Dokument US-A-5 086 332 beschreibt ein Halbleiterbauelement in planarer Bauweise. Auf eine Isolationsschicht ist zwischen Kontaktierungsstellen eine einschichtige, hochohmige SIPOS-Schicht aufgebracht und mit den Kontaktierungsstellen (Elektroden) verbunden. Über den zu kontaktierenden Zonen des Halbleiterkörpers sind Kontaktfenster angeordnet, so dass das Elektrodenmaterial direkt auf die Halbleiterzonen aufgebracht ist. An die Elektroden wird eine Spannung angelegt, wodurch ein elektrisches Feld aufgebaut wird. Durch das elektrische Feld wiederum läßt sich eine hohe Durchbruchspannung des Halbleiterbauelements erzielen.

Aus dem Dokument GB-A-2 128 636 ist ein verbessertes Metallisierungsverfahren zur Ausbildung von Kontaktierungen auf einem Siliziumsubstrat bekannt. Im Bereich einer Kontaktierungsstelle wird Aluminium direkt auf die nur wenige Nanometer dicke, bereits bei Zimmertemperatur durch den Luftsauerstoff auf dem Silizium entstehende Oxidschicht aufgebracht und bei einer Temperatur von ungefähr 450° C gesintert (getempert). Dabei wird die Oxidschicht durch das Aluminium reduziert und es entsteht ein inniger Kontakt zwischen dem Aluminium und dem Silizium.

Ein Verfahren zur Bildung einer selbstjustierenden, niederohmigen und metallischen Nebenschlußkontaktierung und Verbindungsstruktur beschreibt das Dokument US-A-4 648 175. Über zu kontaktierenden Halbleiterzonen eines monokristallinen Siliziumsubstrats wird eine eigenleitende polykristalline oder amorphe Siliziumschicht abgeschieden und optional dotiert. Nach einem Ätzprozess zur Bildung von Kontakt- und Verbindungsstellen wird bei einer Temperatur zwischen 800° C und 1000° C in einer Stickstoffumgebung ein Sinterprozess durchgeführt. Dabei wandern die Dotierungsstoffe aus den untenliegenden Halbleiterzonen in das obenliegende Polysilizium und bilden einen gut leitenden Kontakt zu der auf dem Polysilizium aufgebrachten Metallisierungsebene.

Aus dem Dokument EP-A-0 589 210 ist ein planares Halbleiterbauteil bekannt, bei dessen Herstellung zur Kontaktierung von Anoden/Basis-Elektrode und Emitterdiode zunächst die N-SIPOS-Schicht und in einem späteren Prozeßschritt die O-SIPOS-Schicht abgeätzt wird, wobei die N-SIPOS-Schicht als Ätzmaske für die O-SIPOS-Schicht verwendet wird.

Das Dokument EP-A-0 519 268 zeigt eine Hochspannungshalbleiteranordnung, bei der in einem Ausführungsbeispiel anstatt einer Glaspassivierung eine Isolationsschichtenfolge, bestehend aus einer O-SIPOS-Schicht und einer N-SIPOS-Schicht, vorgesehen ist. Zur Herstellung einer Kontaktierung wird durch beide SIPOS-Schichten ein Kontaktfenster hindurchgeätzt.

Im Dokument Proceedings of the 14th European Solid State Device Research Conference, Lilli, FR, 10.-13.09.1984; Physika B+C, Amsterdam, NL, März 1985, Seiten 234 bis 239; J.N. Sandoe et al.: "Characterisation and modelling of SIPOS on silicon planar devices" wird auf der Basis von elektrischen Kenngrößen die Charakterisierung und Modellierung von SIPOS-Schichten beschrieben.

Und schließlich ist aus dem Dokument US-A-4 717 681 eine Anordnung und ein Herstellungsverfahren für ein Halbleiterbauelement (heterojunction bipolar transistor) bekannt, bei dem einzelne Bereiche aus kristallinem SiOₓ mit sauerstoff- und stickstoffdotierten SIPOS-Schichten passiviert und kontaktiert werden. Zur Herstellung von Kontaktierungen (vias) wird die SIPOS-Schicht geöffnet.

Die Aufgabe der Erfindung besteht darin, ein Verfahren anzugeben, bei dem zum einen nur ein geringer technologischer Aufwand notwendig ist und zum anderen Leitbahnunterbrechungen und Hohlräume im Bereich der Kontaktöffnungsstellen zuverlässig vermieden werden.

Diese Aufgabe wird durch die im kennzeichnenden Teil des Anspruchs 1 beschriebenen Prozeßschritte und der Reihenfolge ihrer Durchführung gelöst.

Hierbei wird gleichzeitig mit der vor dem ganzflächigen Aufbringen der SIPOS-Doppelschicht durchzuführenden Oxidätzung die während der Basisund Emitternachdiffusion entstehenden Oxidschichten in den Kontaktbereichen mittels eines naßchemischen Ätzverfahrens entfernt. Danach wird eine doppelschichtige SIPOS-Passivierung aufgebracht. in dem sich anschließenden Kontaktöffnungsprozeß wird lediglich die oben liegende Schicht abgeätzt.

Die mit der Erfindung erzielten Vorteile bestehen insbesondere darin, daß lediglich durch einfache Änderungen einzelner Prozeßschritte und mit abgeänderten Masken Hohlräume zwischen Leitbahnen und Passivierungsschichten, in denen sich Verunreinigungen mit korrosiver Wirkung ansammeln können und Unterbrechungen der Leitbahnen vermieden werden, ohne daß hierfür zusätzliche Masken - oder Prozeßschritte notwendig sind oder sogar ein neuer Prozeß entwickelt werden muß.

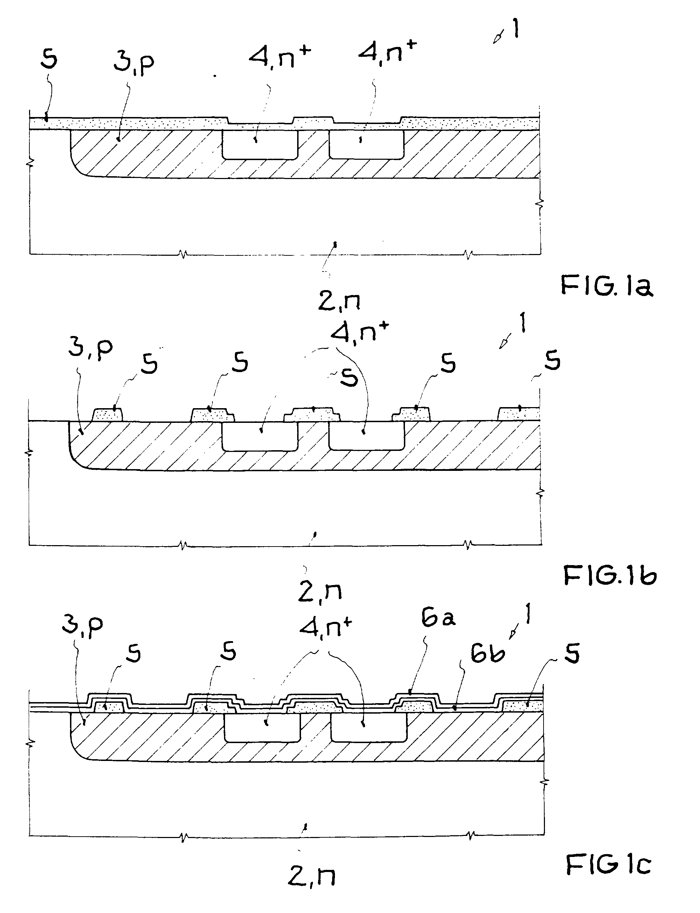

Ein Ausführungsbeispiel des erfindungsgemäßen Verfahrens wird in den Figuren dargestellt und im weiteren näher beschrieben. Es zeigen die Figuren 1a - 1e den skizzierten Querschnitt eines teilweisen Halbleiterkörpers mit den für die Erfindung relevanten Zonen, Schichten und Leitbahnen.

Figur 1a zeigt am Beispiel eines NPN-Transistors einen Halbleiterkörper 1, bestehend aus einem n-dotierten Substrat 2, darin eingebrachten, p-dotierten Basiszonen 3 und einer sich auf der Oberfläche des Substrat 2 befindenen Oxidschicht 5, wobei die Basiszonen 3 mittels eines unter dem Begriff Basisdiffusion an sich bekannten Verfahrens in das Substrat 2 eingebracht werden. In einem weiteren, als Emitternachdiffusion bezeichneten Verfahrensschritt werden in das Substrat 2 und in die Basiszonen 3 höher dotierte und n-leitende Emitterzonen 4 eingebracht.

Figur 1b zeigt den Zustand, wie er sich ergibt, nachdem die Oxidschicht 5 mittels eines Ätzprozesses an den Randbereichen und teilweise von den Basis- und Emitterzonen 3 und 4 entfernt wurde.

Das ganzflächige Entfernen der Oxidschicht 5 mittels eines Ätzprozesses, wozu keine Maske erforderlich ist, ist eine andere Möglichkeit zu der bereits geschilderten Prozeßfolge. Diese Variante sollte dann gewählt werden, wenn ein h_{FE}-Verlust in Kauf genommen werden kann und es für den Anwender bedeutsamer ist, eine Maske weniger erstellen zu müssen.

Figur 1c zeigt den Halbleiterkörper 1 mit der ganzflächig aufgebrachten, doppelschichtigen SIPOS-Passivierung, bestehend aus N-SIPOS 6a und O-SIPOS 6b.

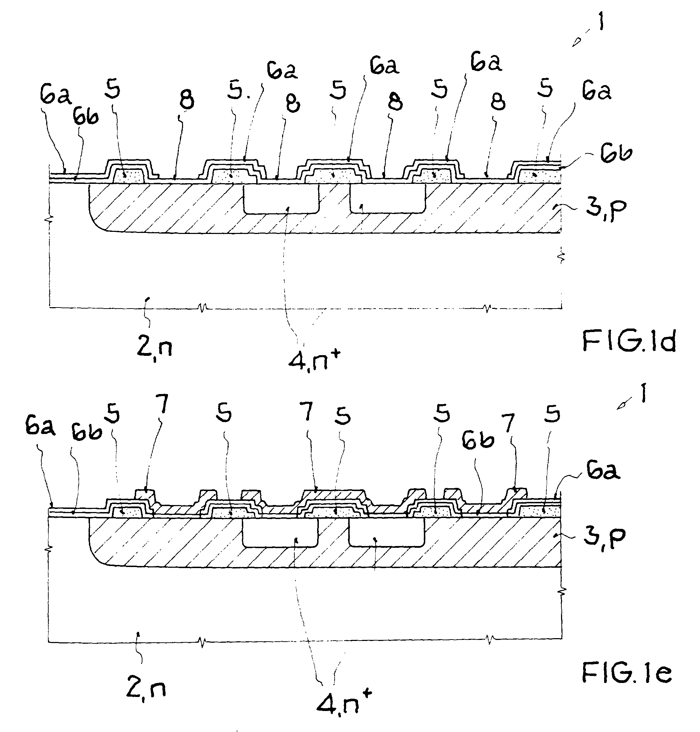

Auf die Passivierung folgen die sogenannten Gelbraumprozesse (belacken, Maske justieren und belichten). Die N-SIPOS-Schicht 6a wird anschließend, wie in Figur 1d dargestellt, mit Hilfe einer Maske in einem Ätzprozeß an all denjenigen Stellen entfernt, die später kontaktiert werden sollen. Daraus ergeben sich die sogenannten Kontaktöffnungen 8. Anschließend wird die Oberfläche des Halbleiterkörpers 1 ganzflächig mit Aluminium bedampft und in einem weiteren Gelbraum- und Ätzprozeß strukturiert.

Aus Figur 1e geht hervor, daß die fast immer aus Aluminium bestehenden Leitbahnen 7 an den im vorhergehenden Prozeßschritt hergestellten Kontaktöffnungen 8 (Figur 1d) direkt auf die nicht entfernte O-SIPOS-Schicht 6b aufgebracht werden.

Es hat sich gezeigt, daß, nachdem die Zwischenschritte Ablacken und Reinigen erfolgt sind, bei der sich anschließenden Wärmebehandlung, dem sogenannten Tempern, das Aluminium der Leitbahnen 7 durch die O-SIPOS-Schicht 6b in das Silizium einwandert und sich daraus nach allen bisherigen Versuchsergebnissen ein recht guter Kontakt bildet, der eine hohe Stromtragfähigkeit aufweist.

Die Leitbahntemperung erfolgt in einem üblichen Wärmeofen bei einer Temperatur zwischen 450 °C und 500 °C.

Die danach folgenden Prozeßschritte, die dem Fachmann bekannt und deshalb in den Figuren nicht dargestellt sind, beinhalten den sogenannten Rückseitenprozeß, bei dem die Rückseite eines Wafers beispielsweise mit einer Chrom-Nickel-Goldschicht überzogen wird, um für diesen im allgemeinen als Kollektoranschluß genutzten Kontakt einen niedrigen Übergangswiderstand und eine hohe Stromtragfähigkeit zu gewährleisten.

Das beschriebene Verfahren eignet sich zur Kontaktierung von SIPOS-passivierten Halbleiterzonen in Dioden-, Transistoren-, GTO-, IGBT-, Power-MOS- oder IC-Strukturen.

## Patentansprüche

1. Verfahren zum Kontaktieren von SIPOS-passivierten Halbleiterzonen eines Halbleiterkörpers (1) mit wenigstens einem pn-Übergang, wobei die Oberfläche des Halbleiterkörpers (1) mittels einer Oxidschicht (5) geschützt ist, mit folgenden Verfahrensschritten:
a) Öffnen der Oxidschicht (5) wenigstens über denjenigen Halbleiterzonen, die kontaktiert werden sollen,
b) Aufbringen einer SIPOS-Passivierung (6a, 6b) auf die Oberfläche des Halbleiterkörpers (1),
c) Entfernen der SIPOS-Passivierung (6a, 6b) über denjenigen Zonen (8), die kontaktiert werden sollen und
d) Aufbringen und Strukturieren von Leitbahnen (7) auf die Kontaktöffnungen (8),
**dadurch gekennzeichnet, dass**
e) beim Herstellen der SIPOS-Passivierung (6a, 6b) auf die Oberfläche des Halbleiterkörpers (1) zuerst eine O-SIPOS-Schicht (6b) und anschließend eine N-SIPOS-Schicht (6a) ganzflächig auf die O-SIPOS-Schicht (6b) aufgebracht wird,
f) beim Entfernen der SIPOS-Passivierung (6a, 6b) nach Verfahrensschritt c) lediglich die N-SIPOS-Schicht (6a) entfernt wird und
g) nach dem Aufbringen und Strukturieren der Leitbahnen (7) eine Wärmebehandlung (Tempern) des Halbleiterkörpers (1) erfolgt, um das Material der Leitbahnen (7) durch die O-SIPOS-Schicht (6b) hindurch in die Oberfläche des Halbleiterkörpers (1) einwandern zu lassen.

2. Verfahren nach Anspruch 1, **dadurch gekennzeichnet, dass** zum Herstellen von Leitbahnen (7) der Halbleiterkörper (1) ganzflächig mit Aluminium bedampft und danach strukturiert wird.

3. Verfahren nach Anspruch 1 oder 2, **dadurch gekennzeichnet, dass** die Wärmebehandlung, das Tempern, des Halbleiterkörpers (1) bei einer Temperatur zwischen 450° C und 500° C durchgeführt wird.

4. Verwendung des Verfahrens nach einem der Ansprüche 1 bis 3 zur Herstellung von Dioden-, Transistoren-, GTO-, IGBT-, Power-MOS- oder IC-Strukturen.

## Claims

1. A method of contacting SIPOS passivated semiconductor zones of a semiconductor body (1) incorporating at least one pn junction whereby the surface of the semiconductor body (1) is protected by means of an oxide layer (5), utilising the following method steps:
a) opening the oxide layer (5) at least above those semiconductor zones with which contact is to be made,
b) applying a SIPOS passivation (6a, 6b) to the surface of the semiconductor body (1),
c) removing the SIPOS passivation (6a, 6b) above those zones (8) with which contact is to be made, and
d) applying and structuring conductive tracks (7) on the contact openings (8),
**characterised in that**
e) when producing the SIPOS passivation (6a, 6b), an O-SIPOS layer (6b) is first applied to the surface of the semiconductor body (1) and an N-SIPOS layer (6a) is thereafter applied over the entire surface of the O-SIPOS layer (6b),
f) when removing the SIPOS passivation (6a, 6b) in accordance with method step c), only the N-SIPOS layer (6a) is removed and
g) after the application and structuring of the conductive tracks (7), a heat treatment (tempering) of the semiconductor body (1) is effected in order to allow the material of the conductive tracks (7) to migrate through the O-SIPOS layer (6b) into the surface of the semiconductor body (1).

2. A method in accordance with Claim 1, **characterised in that**, for the purposes of producing the conductive tracks (7), aluminium is deposited over the entire surface of the semiconductor body (1) and thereafter structured.

3. A method in accordance with Claim 1 or 2, **characterised in that** the heat treatment, the tempering, of the semiconductor body (1) is effected at a temperature of between 450° C and 500° C.

4. The use of the method in accordance with any of Claims 1 to 3 for producing diodes, transistors, GTO-, IGBT-, power MOS- or IC structures.

## Revendications

1. Procédé pour établir un contact avec des zones semiconductrices passivées selon le procédé SIPOS, d'un corps semiconducteur (1) comportant au moins une jonction pn, la surface du corps semiconducteur (1) étant protégée par une couche d'oxyde (5), présentant les étapes opératoires suivantes :
a) ouverture de la couche d'oxyde (5) au moins au-dessus des zones semiconductrices, avec lesquelles un contact doit être établi,
b) dépôt d'une passivation SIPOS (6a,6b) sur la surface du corps semiconducteur (1),
c) retrait de la passivation SIPOS (6a,6b) au-dessus des zones (8), avec lesquelles un contact doit être établi, et
d) dépôt et structuration de voies conductrices (7) sur les ouvertures de contact (8),
**caractérisé en ce que**
e) lors de la fabrication de la passivation SIPOS (6a,6b) sur la surface du corps semiconducteur (1), on dépose tout d'abord une couche O-SIPOS (6b) et une couche N-SIPOS (6a) sur toute la surface de la couche O-SIPOS (6b),
f) lors du retrait de la passivation SIPOS (6a,6b) après l'étape opératoire (c), on retire uniquement la couche N-SIPOS (6a), et
g) après le dépôt et la structuration des voies conductrices (7), on exécute un traitement thermique (recuit) du corps semiconducteur (1), pour amener le matériau des voies conductrices (7) à pénétrer, en traversant la couche O-SIPOS (6b), dans la surface du corps semiconducteur (1).

2. Procédé selon la revendication 1, **caractérisé en ce que** pour la réalisation de voies conductrices (7), on dépose par évaporation de l'aluminium sur toute la surface du corps semiconducteur (1), puis on effectue une structuration.

3. Procédé selon la revendication 1 ou 2, **caractérisé en ce que** le traitement thermique, le recuit, du corps semiconducteur (1) est exécuté à une température comprise entre 450°C et 500°C.

4. Utilisation du procédé selon l'une des revendications 1 à 3 pour fabriquer des structures de diodes, des structures de transistors, des structures GTO, des structures IGTB, des structures MOS de puissance ou des structures de circuits intégrés.
